# EUROPEAN PATENT APPLICATION

(11) **EP 2 026 382 A1**
(43) Date of publication of application: **18.02.2009**
(21) Application number: 07115050.2
(22) Date of filing: 27.08.2007
(51) Int. Cl.: H01L 27/146

(54) **Image sensor package and method for forming the same**

(30) Priority: 16.08.2007 US 840153
(71) Applicant: Kingpak Technology Inc., Chu-Pei Hsin chu 302 (TW)
(72) Inventor: Peng, Chen Pin, 314, Beipu Township,Hsinchu County (TW); Chang, Chien Wei, 305, Xinpu Township, Hsinchu County (TW); Tu, Hsiu-Wen 17,Lanel 172 Guangyang Rd., 302, Tanzih Township, Taichung County (TW); Hsin, Chung-Hsien, 302, Hsinchu City, (TW)
(74) Representative: Collin, Jérôme

(57) **Abstract**

An image sensor package is provided including a substrate; a sensor chip; a plurality of bond wires for connecting the sensor chip to the substrate at predetermined locations; a sensor housing on the substrate for substantially encompassing the sensor chip, the sensor housing having a through-hole cavity defining an optical glass (IR filter) seat, the sensor housing defining an upper surface and an edge surface thereof; an optical glass (IR filter) on the optical glass (IR filter) scat; an encapsulation material for substantially encapsulating the upper surface and edge surface of the sensor housing, a corresponding surface of the substrate adjacent the edge surface of the sensor housing, and the side edge of the optical glass (IR filter); wherein the sensor housing is provided with a gas-exit allowing possible high temperature gas to exit; the encapsulation material forms an upper surface which is substantially aligned with a top surface of the optical glass (IR filter); the encapsulation material forms an upper surface which is lower than a top surface of the optical glass (IR filter); the sensor housing defines a profile shape, the profile shape has at least a step-wise configuration for facilitating and accommodating flowing of the encapsulation material; the sensor housing has a bottom surface adhered to the substrate by an adhesive; and a slot is provided on the bottom surface of the sensor housing for accommodating the adhesive.

## Description

### FIELD OF THE INVENTION

The present invention relates generally to the packaging of image sensor package which manifests the structure robust and high reliability.

### BACKGROUND OF THE INVENTION

A solid-state image sensor device is a photo-electric conversion device for converting the optical signal of image into an electric signal. The Charge Coupled Device (CCD), CIS (Contact Image Sensor) and CMOS image sensors, among others, are examples of the solid-state image sensor device. Assemblies or packaging of image sensor package are well known to those skilled in the art.

Nowadays, the solid-state image sensor devices are employed in either the stationary apparatus or mobile apparatus. Among others, the stationary apparatus includes the camera module of desk-top personal computer (PC) and the mobile apparatus includes the camera module of portable personal computer or mobile phone. More recently, the camera modules are deployed in the field of private or public transportation tools.

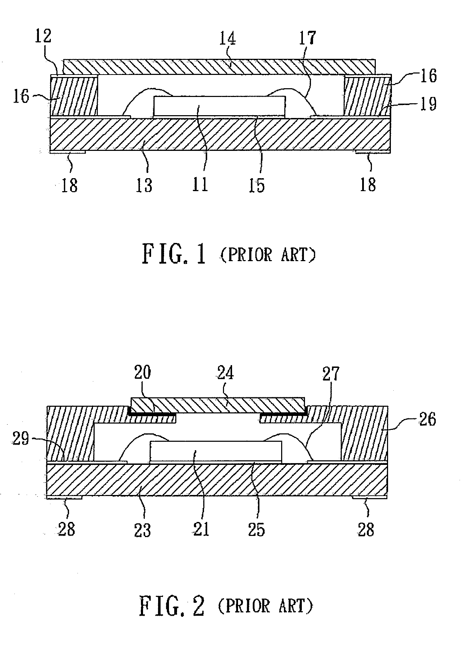

Fig. 1 is a schematic view showing a section of a typical package for an optical device utilized in the stationary apparatus, e.g. the desk-top personal computer. In this typical package, the sensor chip 11 is attached to the upper surface of the substrate 13 through the adhesive layer 15. A plurality of bond wires 17 connect the sensor chip 11 with the internal traces 19 on the substrate 13 at predetermined locations. The external traces 18 of the substrate 13 are electrically connected to the internal traces 19 by the vias (not shown). The plastic or ceramic dam 16 is provided on the substrate 13 for substantially encompassing the sensor chip 11 and for protecting the sensor chip 11. An optical glass (or IR filter) 14 is provided to connect to the top of the plastic or ceramic dam 16 through the adhesive layer 12. The format of package in Fig. 1 is referred to as leadless chip carrier (LCC).

Fig. 2 is a schematic view showing a section of a typical package for an optical device utilized in the mobile apparatus, e.g. the portable personal computer or the mobile phone. In this typical package, the sensor chip 21 is attached to the upper surface of the substrate 23 through the adhesive layer 25. A plurality of bond wires 27 connect the sensor chip 21 with the internal traces 29 on the substrate 23 at predetermined locations. The external traces 28 of the substrate 23 are electrically connected to the internal traces 29 by the vias (not shown). The low-profile sensor housing 26, having an optical glass (IR filter) seat 20 at the central portion of the sensor housing 26, is provided on the substrate 23 for substantially encompassing the sensor chip 21 and for protecting the sensor chip 21. An optical glass or IR filter 24 is received by the optical glass (IR filter) seat 20 and adhered to the optical glass (IR filter) seat 20 of the sensor housing 26.

Compared with other applications, the structure robust and high reliability are more demanding for the image sensor package while being used in high temperature, high humidity and dusty environment. The above mentioned conventional image sensor packages have been found not reliable in the transportation scenarios.

### SUMMARY OF THE INVENTION

It is thus an object of the present invention to address the problems mentioned above to provide an image sensor package and method for improving the structure robust and reliability of the image sensor package.

The object of the present invention is accomplished by the following preferred embodiments.

In accordance with the preferred embodiment of present invention, an image sensor package is provided including a substrate; an image sensor; a plurality of bond wires for connecting the image sensor to the substrate at predetermined locations; a sensor housing on the substrate for substantially encompassing the image sensor, the sensor housing having a through-hole cavity defining an optical glass (IR filter) seat, and the sensor housing defining an edge surface thereof; an optical glass (or IR filter) on the optical glass (IR filter) seat; an encapsulation material for substantially encapsulating the edge surface of the sensor housing and a corresponding surface of the substrate adjacent the edge surface of the sensor housing.

In accordance with still the preferred embodiment of present invention, an image sensor package is provided including a substrate; an image sensor; a plurality of bond wires for connecting the image sensor to the substrate at predetermined locations; a sensor housing on the substrate for substantially encompassing the image sensor, the sensor housing having a through-hole cavity defining an optical glass (IR filter) seat, the sensor housing defining an upper surface and an edge surface thereof; an optical glass or IR filter on the optical glass (IR filter) seat; an encapsulation material for substantially encapsulating the upper surface and edge surface of the sensor housing, a corresponding surface of the substrate adjacent the edge surface of the sensor housing, and the side edge of the optical glass (or IR filter).

In accordance with still the preferred embodiment of present invention, an image sensor package is provided including a substrate; an image sensor; a plurality of bond wires for connecting the image sensor to the substrate at predetermined locations; a sensor housing on the substrate for substantially encompassing the image sensor, the sensor housing having a through-hole cavity defining an optical glass (IR filter) seat, and the sensor housing defining an edge surface thereof; an optical glass or IR filter on the optical glass (IR filter) seat; an encapsulation material for substantially encapsulating the edge surface of the sensor housing and a corresponding surface of the substrate adjacent the edge surface of the sensor housing; wherein the sensor housing is provided with a gas-exit allowing possible high temperature gas to exit; the encapsulation material forms an upper surface which is substantially aligned with a top surface of the sensor housing; the sensor housing defines a profile shape, the profile shape has at least a step-wise configuration for facilitating and accommodating flowing of the encapsulation material; the sensor housing has a bottom surface adhered to the substrate by an adhesive; and a slot, optionally, is provided on the bottom surface of the sensor housing for accommodating the adhesive.

In accordance with still the preferred embodiment of present invention, an image sensor package is provided including a substrate; an image sensor; a plurality of bond wires for connecting the image sensor to the substrate at predetermined locations; a sensor housing on the substrate for substantially encompassing the image sensor, the sensor housing having a through-hole cavity defining an optical glass (IR filter) seat, the sensor housing defining an upper surface and an edge surface thereof; an optical glass (IR filter) on the optical glass (IR filter) seat; an encapsulation material for substantially encapsulating the upper surface and edge surface of the sensor housing, a corresponding surface of the substrate adjacent the edge surface of the sensor housing, and the side edge of the optical glass (IR filter); wherein the sensor housing is provided with a gas-exit allowing possible high temperature gas to exit; the encapsulation material forms an upper surface which is substantially aligned with a top surface of the optical glass (IR filter) or lower than a top surface of the optical glass (IR filter); the sensor housing defines a profile shape, the profile shape has at least a step-wise configuration for facilitating and accommodating flowing of the encapsulation material; the sensor housing has a bottom surface adhered to the substrate by an adhesive; and a slot, optionally, is provided on the bottom surface of the sensor housing for accommodating the adhesive.

In accordance with still the preferred embodiment of present invention, a method for forming an image sensor package including an image sensor chip is provided including (a) providing a substrate and providing a sensor housing having a through-hole cavity defining an optical glass (IR filter) seat, the sensor housing defining an edge surface thereof; (b) mounting the sensor chip on said substrate; (c) wire-bonding the sensor chip to the substrate at predetermined locations by bond wires; (d) mounting an optical glass or IR filter onto the optical glass (IR filter) seat; (e) mounting the sensor housing together with the optical glass or IR filter on the substrate for substantially encompassing the sensor chip; (f) applying an encapsulation material for substantially encapsulating the edge surface of the sensor housing and a corresponding surface of the substrate adjacent the edge surface of the sensor housing.

In accordance with still the preferred embodiment of present invention, a method for forming an image sensor package including a sensor chip is provided including (a) providing a substrate and providing a sensor housing having a through-hole cavity defining an optical glass (IR filter) seat, the sensor housing defining an edge surface thereof; (b) mounting the sensor chip on said substrate; (c) wire-bonding the sensor chip to the substrate at predetermined locations by bond wires; (d) mounting an optical glass or IR filter onto the optical glass (IR filter) seat; (e) mounting the sensor housing together with the optical glass or IR filter on the substrate for substantially encompassing the sensor chip; (f) applying an encapsulation material for substantially encapsulating the upper surface and edge surface of the sensor housing, a corresponding surface of the substrate adjacent the edge surface of the sensor housing, and the side edge of the optical glass (IR filter).

The above mention object and features of the invention will more fully be appreciated from the following detailed description with accompanying drawings.

### BRIEF DESCRIPTION OF THE DRAWINGS

FIG. 1 is a schematic view showing a section of a conventional image sensor package;
FIG. 2 is a schematic view showing a section of another conventional image sensor package;
FIG. 3 is a schematic view showing a section of image sensor package of one preferred embodiment in Ball Grid Array (BGA) format;
FIG. 4 is a schematic view showing a section of image sensor package of another preferred embodiment in Leadless Chip Carrier (LCC) format;
FIG. 5(A) is a schematic view showing a section of image sensor package of still another preferred embodiment in BGA format;
FIG. 5(B) is a schematic view showing a section of image sensor package of still another preferred embodiment in LCC format;
FIG. 6 is a schematic view showing a section of image sensor package of still another preferred embodiment In BGA format;
FIG. 7 shows the exemplified process flow of an actual manufacturing method.

### DETAILED DESCRIPTION OF THE PREFERRED EMBODIMENTS

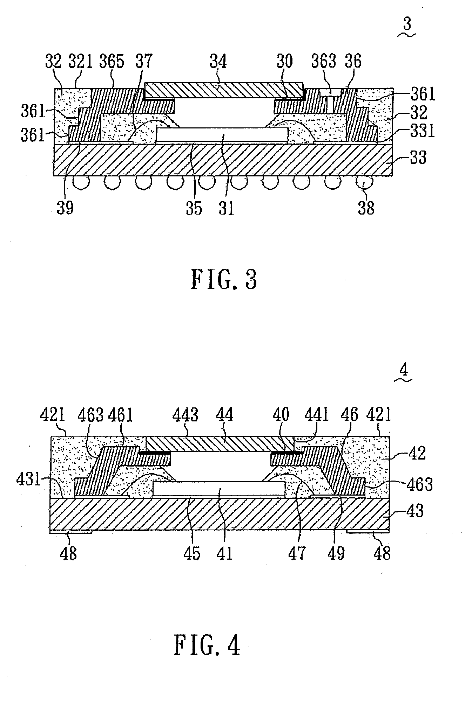

In accordance with one preferred embodiment of present invention, in the image sensor package 3 shown in Fig. 3, the sensor chip 31 is attached to the upper surface of the substrate 33 through the adhesive layer 35. A plurality of bond wires 37 connect the sensor chip 31 with the internal traces 39 on the substrate 33 at predetermined locations. Each internal trace 39 is electrically connected to one corresponding ball 38 by the via (not shown). The low-profile sensor housing 36, having an optical glass (IR filter) seat 30 at the central portion of the sensor housing 36, is provided on the substrate 33 for substantially encompassing the sensor chip 31 and for protecting the sensor chip 31. A transparent optical glass or IR filter 34 is received by the optical glass (IR filter) seat 30 and adhered to the optical glass (IR filter) seat 30 of the sensor housing 36. An encapsulation material 32 is provided for substantially encapsulating the edge surface 361 of the sensor housing 36 and a corresponding surface 331 of the substrate adjacent the edge surface 361 of the sensor housing 36. For this configuration, in a preferred embodiment, the sensor housing 36 is provided with an optional gas-exit 363 allowing possible high temperature gas to exit during curing of sensor housing mounting process. When the optional gas-exit 363 is used, the gas-exit sealant (not shown) is filled within the gas-exit 363 after curing of the sensor housing mounting process. In a preferred embodiment, the encapsulation material forms an upper surface 321 which is substantially aligned with or lower than a top surface 365 of the sensor housing 36. In a preferred embodiment, the sensor housing 36 defines a profile shape, the profile shape has at least a step-wise configuration for facilitating and accommodating flowing of the encapsulation material 32 during its application. By the provision of step-wise configuration, during the application period of the encapsulation material, the flowing control of encapsulation material is enhanced for preventing overflow of the encapsulation material such that contamination to the top surface of the optical glass (IR filter) 34 is avoided. For making the image sensor package disclosed in Fig. 3, a method for forming an image sensor package including an image sensor is provided which includes the following steps:
(a) providing a substrate 33 and providing a sensor housing 36 having a through-hole cavity defining an optical glass (IR filter) seat 30, the sensor housing 36 defining an edge surface 361 thereof;
(b) mounting the sensor chip 31 on said substrate 33;
(c) wire-bonding the sensor chip 31 to the substrate 33 at predetermined locations by bond wires 37;
(d) mounting an optical glass or IR filter 34 onto the optical glass (IR filter) seat 30;
(e) mounting the sensor housing 36 together with the optical glass or IR filter 34 on the substrate 33 for substantially encompassing the sensor chip 31;
(f) applying an encapsulation material 32 for substantially encapsulating the edge surface 361 of the sensor housing 36 and a corresponding surface 331 of the substrate adjacent the edge surface 361 of the sensor housing 36. In a preferred embodiment, during the step (e), an encapsulation material is substantially disposed over the bond wires 37. After the step (f), a ball mounting process may be performed resulting in the image sensor package of ball grid array (BGA) format shown in Fig. 3. It is noted that when the optional gas-exit 363 is used, the gas-exit sealant (not shown) is filled within the gas-exit 363 by an additional process after curing of the sensor housing mounting process. Variations are made to the above mentioned embodiment.

In accordance with another preferred embodiment of present invention, in the image sensor package 4 shown in Fig. 4, the sensor chip 41 is attached to the upper surface of the substrate 43 through the adhesive layer 45. A plurality of bond wires 47 connect the sensor chip 41 with the internal traces 49 on the substrate 43 at predetermined locations. The external traces 48 of the substrate 43 are electrically connected to the internal traces 49 by the vias (not shown). The low-profile sensor housing 46, having an optical glass (IR filter) seat 40 at the central portion of the sensor housing 46, is provided on the substrate 43 for substantially encompassing the sensor chip 41 and for protecting the sensor chip 41. A transparent optical glass or IR filter 44 is received by the optical glass (IR filter) seat 40 and adhered to the optical glass (IR filter) seat 40 of the sensor housing 46. The sensor housing 46 defines an upper surface 461 and an edge surface 463. In this embodiment, the upper surface 461 of sensor housing 46 is lower than the top surface 443 of the transparent optical glass (IR filter) 44. An encapsulation material 42 is provided for substantially encapsulating the upper surface 461 and edge surface 463 of the sensor housing 46, a corresponding surface 431 of the substrate adjacent the edge surface 463 of the sensor housing 46, and the side edge 441 of the optical glass (IR filter) 44. In a preferred embodiment, the sensor housing 46 defines a profile shape, the profile shape has at least a step-wise configuration for facilitating and accommodating flowing of the encapsulation material 42 during its application. By the provision of step-wise configuration, during the application period of the encapsulation material, the flowing control of encapsulation material is enhanced for preventing overflow of the encapsulation material such that contamination to the top surface 443 of the optical glass (IR filter) 44 is avoided. For making the image sensor package 4 disclosed in Fig. 4, a method for forming an image sensor package including an sensor chip is provided which includes the following steps:
(a) providing a substrate 43 and providing a sensor housing 46 having a through-hole cavity defining an optical glass (IR filter) seat 40, the sensor housing 46 defining an edge surface 463 thereof;
(b) mounting the sensor chip 41 on said substrate 43;
(c) wire-bonding the sensor chip 41 to the substrate 43 at predetermined locations by bond wires 47;
(d) mounting an optical glass (IR filter) 44 onto the optical glass (IR filter) seat 40;
(e) mounting the sensor housing 46 along with the optical glass (IR filter) 44 on the substrate 43 for substantially encompassing the sensor chip 41;
(f) applying an encapsulation material 42 for substantially encapsulating the upper surface 461 and edge surface 463 of the sensor housing 46, a corresponding surface 431 of the substrate adjacent the edge surface 463 of the sensor housing 46, and the side edge 441 of the optical glass (IR filter) 44. In a preferred embodiment, during the step (e), an encapsulation material is substantially disposed over the bond wires 47. In a preferred embodiment, the encapsulation material 42 forms an upper surface 421 which is substantially aligned with or lower than a top surface 443 of the optical glass (IR filter) 44.

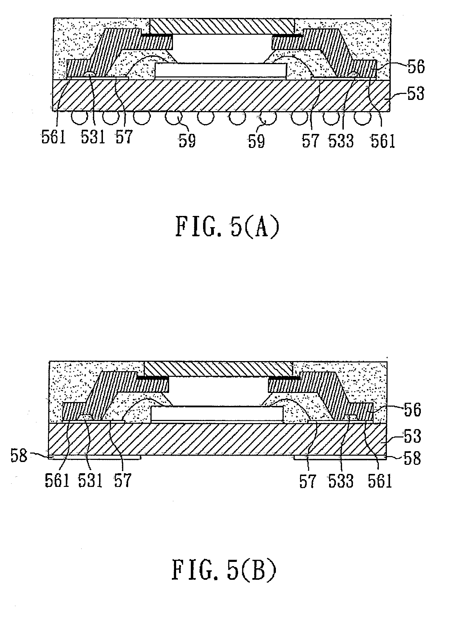

Modifications or variations to the disclosed embodiments are still possible. For instance, in the preferred embodiment shown in Fig. 5(A) and Fig. 5(B), the sensor housing 56 has a bottom surface 561 adhered to the substrate 53 by an adhesive 531, and a slot 533 is provided on the bottom surface 561 of the sensor housing 56 for accommodating the adhesive 531. By this configuration, reliability of adhesive connection between the bottom surface 561 and the corresponding surface of substrate 53 is significantly improved. The cross-section of slot 533 may be in form a semicircle-like shape shown in Fig. 5(A) or a trapezoid-like shape shown in Fig. 5(B). The external traces 58 of the substrate 53 are electrically connected to the internal traces by the vias (not shown) in Fig. 5(B) for LCC format. Likewise, in Fig. 5(A), the internal trace 57 is electrically connected, by via (not shown), to one corresponding ball 59 for BGA format.

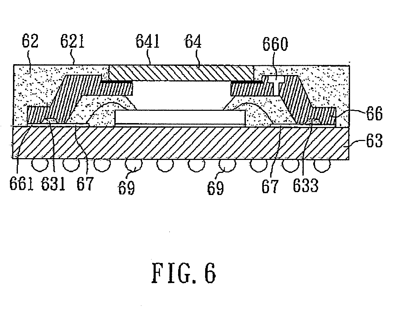

As all features disclosed above are deployed, the resultant image sensor package 6 is shown in Fig. 6. In this preferred embodiment, the sensor housing 66 is provided with a gas-exit 660 allowing possible high temperature gas to exit during curing of sensor housing mounting process. Without provision of the gas-exit 660, it is possible the sensor housing 66 tilts (deflects) relative to the substrate 63 due to existence of the high temperature gas in the internal space of the sensor housing 66. The encapsulation material 62 forms an upper surface 621 which is substantially aligned with a top surface 641 of the optical glass (IR filter) 64. Or alternatively, the encapsulation material 62 forms an upper surface 621 which is lower than the top surface 641 of the optical glass (IR filter) 64. The sensor housing 66 defines a profile shape, the profile shape has at least a step-wise configuration for facilitating and accommodating flowing of the encapsulation material 62. The sensor housing 66 has a bottom surface 661 adhered to the substrate 63 by an adhesive 631, and a slot 633 is provided on the bottom surface 661 of the sensor housing 66 for accommodating the adhesive 631. By this configuration, reliability of adhesive connection between the bottom surface 661 and the corresponding surface of substrate 63 is significantly improved. The cross-section of slot 633 may be in form a semicircle-like shape or a trapezoid-like shape. The internal trace 67 is electrically connected, by via (not shown), to one corresponding ball 69 for the package of BGA format shown in Fig. 6.

The above embodiments of the present invention have been described in details in terms of mixture of legal and technical languages while not mentioning some technical details well known in the art, e.g., curing steps. The more details of image sensor package of the invention can be further understood by following example in terms of real world technical languages.

### EXAMPLE

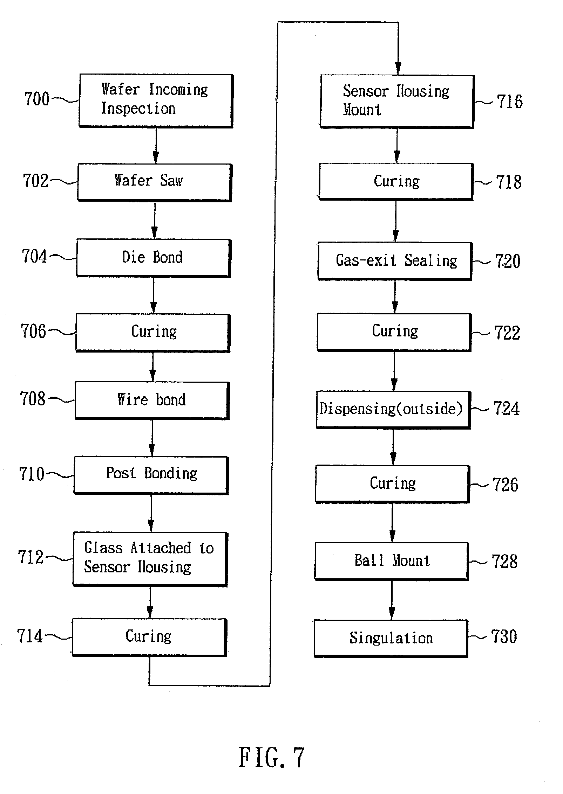

The process flow of making the image sensor package of the present invention is disclosed in Fig. 7. As shown, in step 700, the wafer having a plurality of image sensor chips is inspected. In step 702, the wafer is sawed to obtain multiple discrete image sensor chips (dies). In step 704, each die is bonded to the substrate by the adhesive. In step 706, curing is performed to cure the adhesive. In step 708, wire bonding is performed. In step 710, post bonding inspection is done. In step 712, the optical glass or IR filter is attached to the sensor housing by the adhesive. In step 714, curing is performed to cure the adhesive. In step 716, the sensor housing together with the optical glass (or IR filter) is mounted to the substrate by the adhesive. In step 718, curing is performed. In step 720 (optional), the gas-exit (optional) is sealed by the sealing material. In step 722, the gas-exit sealant curing is performed. In step 724, dispensing of encapsulation material is performed over the sensor housing and adjacent areas of the substrate. In step 726, another curing is performed. In step 728 (optional), solder ball mounting is performed underneath the substrate to obtain the image sensor package in Ball Grid Array (BGA) format. Or alternatively, we may dispense with ball mounting and leave the bottom lead resulting in an image sensor package of leadless chip carrier (LCC) format. In step 730, singulation of the substrate and encapsulation material is performed and multiple image sensor packages are obtained. Or alternatively, sequence of step 728 and 730 can be reversed.

The encapsulation material disclosed above is available from Henkel International Inc. (http://www.henkel.com), e.g. FP 4802 resins.

By the disclosed embodiments, it is found that the structural robust and reliability of the image sensor package is greatly improved while being used in severe environments.

The drawings and the foregoing description give examples of the present invention. The scope of the present invention, however, is by no means limited by these specific examples. Various variations, whether explicitly given in the specification or not, are possible. For instance, the optical glass may be substituted by the IR filter. The scope of the invention is only limited by the following claims and their equivalents.

## Claims

1. A method for forming an image sensor package including a sensor chip, comprising:
(a) providing a substrate and providing a sensor housing having a through-hole cavity defining an optical glass seat, the sensor housing defining an edge surface thereof;
(b) mounting the sensor chip on said substrate;
(c) wire-bonding the sensor chip to the substrate at predetermined locations by bond wires;
(d) mounting an optical glass or IR filter onto the optical glass seat;
(e) mounting the sensor housing together with the optical glass or IR filter on the substrate for substantially encompassing the sensor chip;
(f) applying an encapsulation material for substantially encapsulating the edge surface of the sensor housing and a corresponding surface of the substrate adjacent the edge surface of the sensor housing.

2. The method of claim 1, during the step (e), an encapsulation material is substantially disposed over the bond wires.

3. The method of claim 1, wherein the sensor housing is provided with a gas-exit allowing possible high temperature gas to exit.

4. The method of claim 1, wherein the encapsulation material forms an upper surface which is substantially aligned with or lower than a top surface of the sensor housing.

5. The method of claim 1, wherein the image sensor package is obtained as a leadless chip carrier (LCC) format.

6. The method of claim 1, wherein after the step (f) a ball mounting process is performed resulting in the image sensor package of ball grid array (BGA) format.

7. The method of claim 3, wherein after curing of the image sensor package obtained between steps (e) and (f), the gas-exit is filled with sealing material.

8. A method for forming an image sensor package including a sensor chip, comprising:
(a) providing a substrate and providing a sensor housing having a through-hole cavity defining an optical glass seat, the sensor housing defining an edge surface thereof;
(b) mounting the sensor chip on said substrate;
(c) wire-bonding the sensor chip to the substrate at predetermined locations by bond wires;
(d) mounting an optical glass or IR filter onto the optical glass seat;
(e) mounting the sensor housing together with the optical glass or IR filter on the substrate for substantially encompassing the sensor chip;
(f) applying an encapsulation material for substantially encapsulating the upper surface and edge surface of the sensor housing, a corresponding surface of the substrate adjacent the edge surface of the sensor housing, and the side edge of the optical glass or IR filter.

9. The method of claim 8, during the step (e), an encapsulation material is substantially disposed over the bond wires.

10. The method of claim 8, wherein the sensor housing is provided with a gas-exit allowing possible high temperature gas to exit.

11. The method of claim 8, wherein the encapsulation material forms an upper surface which is substantially aligned with or lower than a top surface of the optical glass or IR filter.

12. The method of claim 8, wherein the image sensor package is obtained as a leadless chip carrier (LCC) format.

13. The method of claim 8, wherein after the step (f) a ball mounting process is performed resulting in the image sensor package of ball grid array (BGA) format.

14. The method of claim 10, wherein after curing of the image sensor package obtained between steps (e) and (f), the gas-exit is filled with sealing material.

15. An image sensor package, comprising:
a substrate;
a sensor chip;
a plurality of bond wires for connecting the sensor chip to the substrate at predetermined locations;
a sensor housing on the substrate for substantially encompassing the sensor chip, the sensor housing having a through-hole cavity defining an optical glass seat, and the sensor housing defining an edge surface thereof;
an optical glass or IR filter on the optical glass seat;
an encapsulation material for substantially encapsulating the edge surface of the sensor housing and a corresponding surface of the substrate adjacent the edge surface of the sensor housing.

16. The image sensor package of claim 15, wherein the sensor housing is provided with a gas-exit allowing possible high temperature gas to exit.

17. The image sensor package claim 15, wherein the encapsulation material forms an upper surface which is substantially aligned with or lower than a top surface of the sensor housing.

18. The image sensor package claim 15, wherein the sensor housing defines a profile shape, the profile shape has at least a step-wise configuration for facilitating and accommodating flowing of the encapsulation material.

19. The image sensor package claim 15, wherein the sensor housing has a bottom surface adhered to the substrate by an adhesive, and wherein a slot is provided on the bottom surface of the sensor housing for accommodating the adhesive.

20. An image sensor package, comprising:
a substrate;
a sensor chip;
a plurality of bond wires for connecting the sensor chip to the substrate at predetermined locations;
a sensor housing on the substrate for substantially encompassing the sensor chip, the sensor housing having a through-hole cavity defining an optical glass seat, the sensor housing defining an upper surface and an edge surface thereof;
an optical glass or IR filter on the optical glass seat;
an encapsulation material for substantially encapsulating the upper surface and edge surface of the sensor housing, a corresponding surface of the substrate adjacent the edge surface of the sensor housing, and the side edge of the optical glass or IR filter.

21. The image sensor package of claim 20, wherein the sensor housing is provided with a gas-exit allowing possible high temperature gas to exit.

22. The image sensor package of claim 20, wherein the encapsulation material forms an upper surface which is substantially aligned with or lower than a top surface of the optical glass or IR filter.

23. The image sensor package claim 20, wherein the encapsulation material forms an upper surface which is lower than a top surface of the optical glass or IR filter.

24. The image sensor package claim 20, wherein the sensor housing defines a profile shape, the profile shape has at least a step-wise configuration for facilitating and accommodating flowing of the encapsulation material.

25. The image sensor package claim 20, wherein the sensor housing has a bottom surface adhered to the substrate by an adhesive, and wherein a slot is provided on the bottom surface of the sensor housing for accommodating the adhesive.

26. An image sensor package, comprising:
a substrate;
a sensor chip;
a plurality of bond wires for connecting the sensor chip to the substrate at predetermined locations;
a sensor housing on the substrate for substantially encompassing the sensor chip, the sensor housing having a through-hole cavity defining an optical glass seat, and the sensor housing defining an edge surface thereof;
an optical glass or IR filter on the optical glass seat;
an encapsulation material for substantially encapsulating the edge surface of the sensor housing and a corresponding surface of the substrate adjacent the edge surface of the sensor housing;
wherein the sensor housing is provided with a gas-exit allowing possible high temperature gas to exit; the encapsulation material forms an upper surface which is substantially aligned with or lower than a top surface of the sensor housing; the sensor housing defines a profile shape, the profile shape has at least a step-wise configuration for facilitating and accommodating flowing of the encapsulation material; the sensor housing has a bottom surface adhered to the substrate by an adhesive; and a slot is provided on the bottom surface of the sensor housing for accommodating the adhesive.

27. An image sensor package, comprising:
a substrate;
a sensor chip;
a plurality of bond wires for connecting the sensor chip to the substrate at predetermined locations;
a sensor housing on the substrate for substantially encompassing the sensor chip, the sensor housing having a through-hole cavity defining an optical glass seat, the sensor housing defining an upper surface and an edge surface thereof;
an optical glass or IR filter on the optical glass seat;
an encapsulation material for substantially encapsulating the upper surface and edge surface of the sensor housing, a corresponding surface of the substrate adjacent the edge surface of the sensor housing, and the side edge of the optical glass or IR filter;
wherein the sensor housing is provided with a gas-exit allowing possible high temperature gas to exit; the encapsulation material forms an upper surface which is substantially aligned with or which is lower than a top surface of the optical glass or IR filter; the sensor housing defines a profile shape, the profile shape has at least a step-wise configuration for facilitating and accommodating flowing of the encapsulation material; the sensor housing has a bottom surface adhered to the substrate by an adhesive; and a slot is provided on the bottom surface of the sensor housing for accommodating the adhesive.
